(19) Europäisches Patentamt / European Patent Office / Office européen des brevets

(11) **EP 4 300 386 A1**

(12) **EUROPEAN PATENT APPLICATION**
published in accordance with Art. 153(4) EPC

(43) Date of publication:
**03.01.2024 Bulletin 2024/01**

(21) Application number: **22827474.2**

(22) Date of filing: **17.06.2022**

(51) International Patent Classification (IPC):
***G06Q 10/04*** *(2023.01)*

(52) Cooperative Patent Classification (CPC):
**G06N 3/04; G06N 3/08; G06Q 10/04**

(86) International application number:
**PCT/CN2022/099307**

(87) International publication number:
**WO 2022/267979 (29.12.2022 Gazette 2022/52)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.06.2021 CN 202110711103**

(71) Applicant: **BYD Company Limited
Shenzhen, Guangdong 518118 (CN)**

(72) Inventors:
• **DENG, Linwang
Shenzhen Guangdong 518118 (CN)**
• **FENG, Tianyu
Shenzhen Guangdong 518118 (CN)**
• **ZHANG, Pengqing
Shenzhen Guangdong 518118 (CN)**
• **LI, Xiaoqian
Shenzhen Guangdong 518118 (CN)**

(74) Representative: **DehnsGermany Partnerschaft
von Patentanwälten
Theresienstraße 6-8
80333 München (DE)**

(54) **METHOD, APPARATUS AND DEVICE FOR PREDICTING POWER BATTERY CAPACITY**

(57) A method for predicting a capacity of a power battery includes the following steps: acquiring sample data of the power battery; dividing the sample data into several categories by using a clustering algorithm, each category having a corresponding aging model and a feature identifier; acquiring battery state parameters of a to-be-tested power battery; determining an aging model adopted by the battery state parameters from multiple aging models; and inputting the battery state parameters into the adopted aging model to obtain a corresponding battery capacity. The aging model may be obtained by the following steps: determining a fitting relationship in the aging model, and determining parameters in the fitting relationship according to sample data of the corresponding type of the aging model.

FIG. 1

EP 4 300 386 A1

## Description

## CROSS-REFERENCE TO RELATED APPLICATIONS

The present disclosure claims priority to and benefits of Chinese Patent Application No. 202110711103.9, entitled "METHOD, APPARATUS, AND DEVICE FOR PREDICTING CAPACITY OF POWER BATTERY", and filed on June 25, 2021, which is incorporated herein by reference in its entirety.

## FIELD

The present disclosure relates to the technical field of battery management, and more specifically, to a method for predicting a capacity of a power battery, an apparatus for predicting a capacity of a power battery, a device for predicting a capacity of a power battery, and a corresponding storage medium.

## BACKGROUND

A power battery is an important component of an electric vehicle. Lifespan is a major performance index of the power battery. Accurately predicting the lifespan not only helps to understand the degradation status of the battery, provide accurate vehicle operating status information for a user, and provide a basis for cost calculation in vehicle production and manufacturing, but also helps to prevent the occurrence of faults and disasters, thereby ensuring the safety of life and property of the user.

The lifespan of the power battery is typically estimated by an experimental method and a model method.

In the experimental method, during actual operation of the vehicle, the current of the power battery is not constant, leading to inaccurate prediction results. In addition, standard new European driving cycle (NEDC) conditions may be adopted to simulate actual working conditions for discharge testing, but the test cycle is too long.

The model method mainly adopts a mechanism model and a statistical model. The mechanism model includes an electrochemical analysis method, an impedance method, etc. The statistical model mainly refers to a lifespan prediction model designed based on a neural network, such as a lifespan prediction method based on a long short-term memory (LSTM) neural network and transfer learning, and a deep learning method for predicting lifespan of lithium batteries. Actual vehicle driving conditions are complex, mechanism model parameters are hard to acquire, and it is difficult to accurately predict the battery lifespan.

## SUMMARY

In view of this, the present disclosure aims to propose a method, apparatus, and device for predicting a capacity of a power battery to at least partially solve the problems that in related arts, an experimental method is long in test cycle, and in a model method, parameters are hard to acquire, and model complexity is high.

In order to achieve the above objectives, the present disclosure provides a method for predicting a capacity of a power battery. The prediction method includes the following: Sample data of the power battery is acquired. The sample data is divided into several categories by using a clustering algorithm, and each category has a corresponding aging model and a feature identifier. The aging model is obtained by the following steps: A fitting relationship in the aging model is determined. Parameters in the fitting relationship are determined according to sample data of the corresponding type of the aging model. The feature identifier is used for identifying features of the sample data of the corresponding category. Battery state parameters of a to-be-tested power battery are acquired. An aging model adopted by the battery state parameters is determined from multiple aging models. The battery state parameters are input into the adopted aging model to obtain a corresponding battery capacity.

According to an embodiment of the present disclosure, the sample data of the power battery includes: multiple sets of historical data for the same model of power battery under actual vehicle driving conditions.

According to an embodiment of the present disclosure, the step that the sample data is divided into several categories by using a clustering algorithm includes the following: The clustering algorithm is preset, and clustering parameters in the clustering algorithm are determined. The sample data is divided into a core point or a boundary point according to the clustering parameters. Categories are constructed according to the core point, and the sample data is divided into the several categories.

According to an embodiment of the present disclosure, the clustering algorithm is a DBSCAN algorithm; and the clustering parameters include a radius of neighborhood and a neighborhood count threshold.

According to an embodiment of the present disclosure, the feature identifier is a clustering center; and the feature identifier is the clustering center. The step that an aging model adopted by the battery state parameters is determined from multiple aging models includes the following: A distance between the battery state parameters and a clustering center corresponding to each category is calculated. A nearest aging model is selected as the aging model adopted by the battery state parameters.

According to an embodiment of the present disclosure, the fitting relationship includes polynomial fitting, neural network fitting, or regression tree fitting.

According to an embodiment of the present disclosure, the battery state parameters include: at least two of current, voltage, temperature, state of charge, storage time, depth of discharge, and coulombic efficiency.

In a second aspect of the present disclosure, an apparatus for predicting a capacity of a power battery is further provided, and includes: an input unit, configured to acquire battery state parameters; a matcher, configured to be matched with the battery state parameters, so as to determine an aging model adopted by the battery state parameters from multiple aging models, where the multiple aging models are in one-to-one correspondence with several categories of sample data divided by a clustering algorithm, and each of the aging models includes a mapping relationship between the battery state parameters and the battery capacity; and a calculator, configured to input the battery state parameters into the adopted aging model, to obtain the corresponding battery capacity.

In a third aspect of the present disclosure, a device for predicting a capacity of a power battery is further provided, and includes: at least one processor, and a memory connected with the at least one processor. The memory stores instructions executable by the at least one processor, and the at least one processor implements a foregoing method for predicting a capacity of a power battery by executing the instructions stored in the memory.

In a fourth aspect of the present disclosure, a computer-readable storage medium is further provided, and stores a computer program. The program, when executed by a processor, implements a foregoing method for predicting a capacity of a power battery.

Compared with the related arts, the method, apparatus, and device for predicting a capacity of a power battery according to the implementations of the present disclosure have following beneficial effects:

Through the above implementations provided by the present disclosure, multiple aging types can be distinguished, and thus, the corresponding aging models are established according to different aging types, thereby improving precision of the aging models, and more accurately predicting the capacity of the power battery. When the sample data becomes more abundant, there are an increasing number of different aging types of data and a wider coverage of different aging types, the clustering algorithm can distinguish different categories more comprehensively, and a distinguishing effect is more intuitive and reliable.

Other features and advantages of the present disclosure will be described in detail in the following detailed description part.

## BRIEF DESCRIPTION OF THE DRAWINGS

The accompanying drawings constituting a part of the present disclosure are used for providing further understanding of the present disclosure. Exemplary implementations of the present disclosure and descriptions thereof are used for explaining the present disclosure, and do not constitute an improper limitation to the present disclosure. In the accompanying drawings:

FIG. 1 is a schematic flowchart of a method for predicting a capacity of a power battery according to the implementation of the present disclosure;

FIG. 2 is a flowchart of a clustering algorithm in a method for predicting a capacity of a power battery according to the implementation of the present disclosure;

FIG. 3 is a schematic diagram of calculation of clustering center distances in a method for predicting a capacity of a power battery according to the implementation of the present disclosure;

FIG. 4 is a schematic flowchart of an implementation of a method for predicting a capacity of a power battery according to the implementation of the present disclosure; and

FIG. 5 is a schematic structural diagram of an apparatus for predicting a capacity of a power battery according to the implementation of the present disclosure.

## DETAILED DESCRIPTION

It is to be noted that, implementations in the present disclosure and features in the implementations may be combined with each other in the case of no conflict.

The present disclosure is described in detail with reference to the accompanying drawings and in combination with the implementations as below.

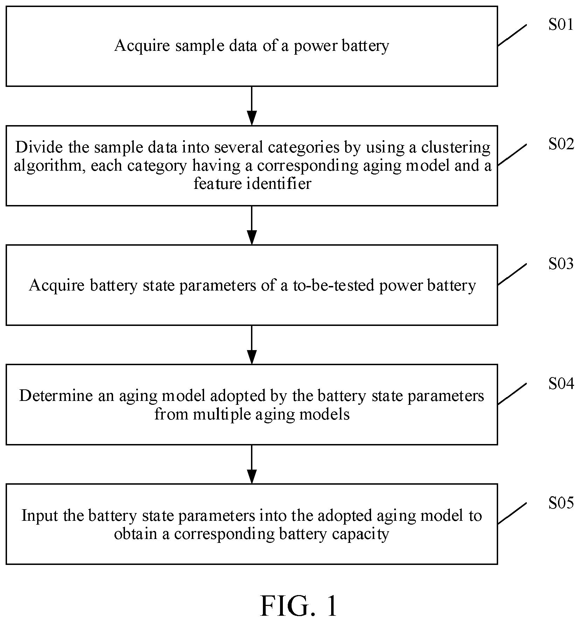

FIG. 1 is a schematic flowchart of a method for predicting a capacity of a power battery according to the implementation of the present disclosure, as shown in FIG. 1. A method for predicting a capacity of a power battery is provided. The prediction method includes the following:

S01: Sample data of the power battery is acquired.

The sample data can be acquired from the power battery under actual vehicle driving conditions, and the sample data can include current I, voltage V, temperature T, state of charge SOC, storage time t, depth of discharge DOD, and coulombic efficiency $\mu$, or a combination of parameters selected therefrom.

S02: The sample data is divided into several categories by using a clustering algorithm, and each category determines a corresponding aging model and a feature identifier. The aging model is obtained by the following steps: A fitting relationship in the aging model is determined. Parameters in the fitting relationship are determined according to sample data of the corresponding type of the aging model. The feature identifier is used for identifying features of the sample data of the corresponding category.

The sample data is classified, and each category of sample data has a certain similarity or intrinsic correlation. By classifying the sample data through the clustering algorithm, a classification result can be rapidly obtained, and the classification result is desirable. The clustering algorithm may be selected from existing clustering algorithms according to actual needs. The aging model is required to be determined for each category. The aging model is a mathematical model, and it is necessary to first determine a fitting relationship in the mathematical model, that is, to select an appropriate fitting function. Then, the fitting relationship is trained or corrected by the sample data within the category, so as to determine the parameters in the fitting relationship, and thus, the aging model for calculating the battery capacity based on input parameters is obtained.

S03: Battery state parameters of the to-be-tested power battery are acquired.

The battery state parameters acquired herein serve as input parameters for predicting capacity, which contain the parameters that are the same as or have a subset relationship with the parameters in the sample data in step S01.

S04: An aging model adopted by the battery state parameters is determined from multiple aging models.

It is necessary to first determine the aging model adopted for the specific battery state parameters, and based on the same battery state parameters, different battery capacities may be obtained according to different aging models. In this implementation, the adopted aging model is determined according to the feature identifier. By determining the appropriate aging model, more accurate battery capacity can be calculated.

S05: The battery state parameters are input into the adopted aging model to obtain a corresponding battery capacity. The aging model adopted in this step is the aging model determined in step S04, and is configured to obtain the corresponding battery capacity according to the battery state parameters, that is, the corresponding battery capacity can be obtained by inputting the battery state parameters.

Through the above implementation, multiple aging types can be distinguished, and thus, the corresponding aging models are established according to different aging types, thereby improving precision of the aging models, and more accurately predicting the capacity of the power battery. When the sample data becomes more abundant, there are an increasing number of different aging types of data and a wider coverage of different aging types, the clustering algorithm can distinguish different categories more comprehensively, and a distinguishing effect is more intuitive and reliable.

In an implementation provided by the present disclosure, the sample data of the power battery includes: multiple sets of historical data for the same model of power battery under actual vehicle driving conditions. The historical data under the actual vehicle driving conditions is adopted as samples, which can better reflect real scenarios and facilitate the acquisition of a large number of samples. Through a large number of sample data that reflects the actual state of multiple power batteries, the defects of the experimental method and the model method are overcome, which can make clustering more accurate and thus make the predication of the battery capacity more accurate.

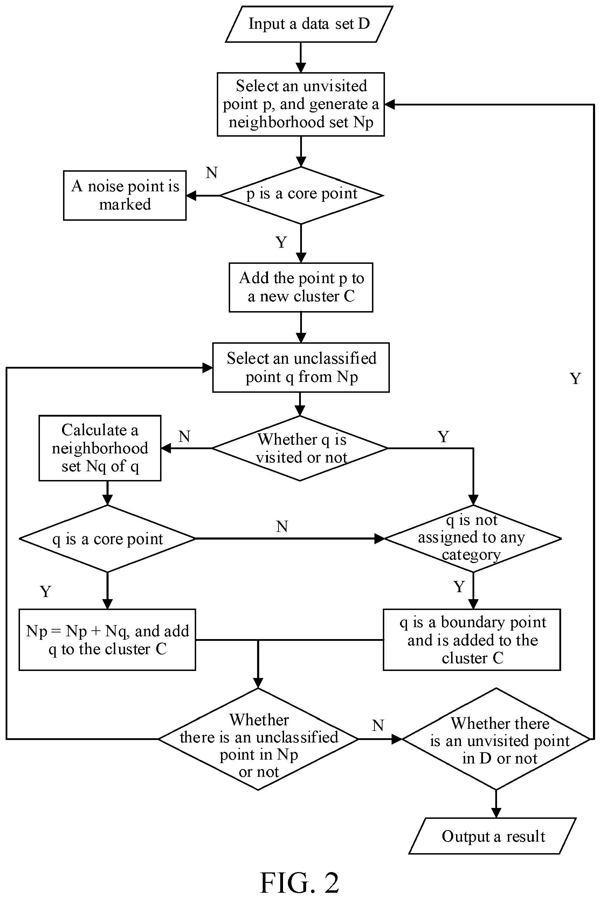

FIG. 2 is a flowchart of a clustering algorithm in a method for predicting a capacity of a power battery according to the implementation of the present disclosure, as shown in FIG. 2. In this implementation, the step that the sample data is divided into several categories by using a clustering algorithm includes the following: The clustering algorithm is preset, and clustering parameters in the clustering algorithm are determined. The sample data is divided into a core point or a boundary point according to the clustering parameters. Categories are constructed according to the core point, and the sample data is divided into the several categories. Further, the clustering algorithm is a DBSCAN algorithm; and the clustering parameters include a radius of neighborhood Eps and a neighborhood count threshold Minpts. A specific process is as below: in an embodiment, a data set is first scanned, an unvisited point p is selected, and a neighborhood set Np is generated. If the count within Eps(p) is greater than Minpts, p is judged as the core point, and a new cluster C is generated. Then, an unclassified point q in Np is selected. If q is not visited, a neighborhood set Nq is generated. If the count in Eps(q) is greater than Minpts, q is judged as the core point, and Np is updated as Np = Np + Nq. The point q is added to the cluster C, if q is neither the core point nor assigned to any category, and q is judged as the boundary point to be added to the cluster C. The process continues until Np no longer contains unclassified points. Following this, if there are still unvisited points in the data set D, the second step is repeatedly performed, and an unvisited point is selected. Through the above method, the sample data is divided into the foregoing several categories.

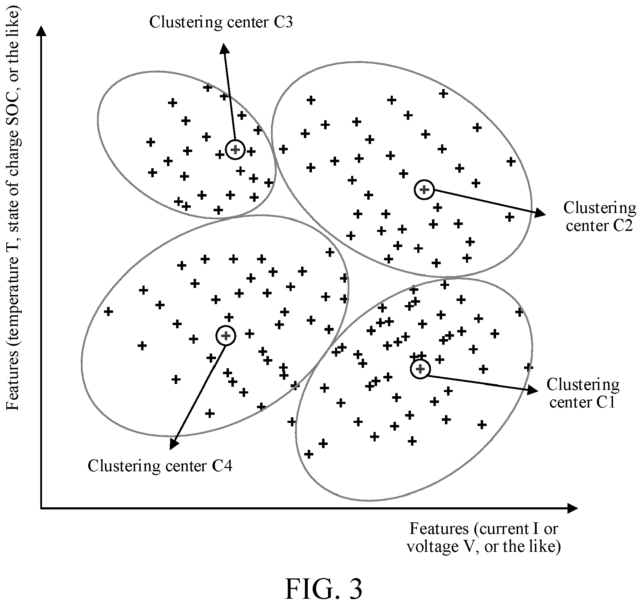

FIG. 3 is a schematic diagram of calculation of clustering center distances in a method for predicting a capacity of a power battery according to the implementation of the present disclosure, as shown in FIG. 3. In this implementation, feature identifiers are clustering centers. The step that an aging model adopted by the battery state parameters is determined from multiple aging models includes the following: A distance between the battery state parameters and a clustering center corresponding to each category is calculated. A nearest aging model is selected as the aging model adopted by the battery state parameters. The figure only shows the situation of four clustering centers C1-C4, and the number of the clustering centers does not limit the number of types. Common clustering calculations in clustering analysis include Euclidean distance, Manhattan distance, Chebyshev distance, and the like, which are primarily used for measuring similarity. By the calculation according to the above method, the similarity (distance) between two objects can be obtained. In the practical calculation, effective selection is performed according to attribute characteristics of different objects. The calculation of the distance between the objects is crucial in the clustering algorithm process as it directly affects the effectiveness of the algorithm, and thus, selection is required to be careful when making practical selections.

In an implementation provided by the present disclosure, the fitting relationship includes polynomial fitting, neural network fitting, or regression tree fitting. The polynomial fitting includes: $y=p_{0}x^n + p_{1}x^{n-1} + p_{2}x^{n-2} + p_{3}x^{n-3} +...+p_{n}$. The number of terms in the polynomial may be determined as needed. The neural network fitting includes: a convolutional neural network (CNN), a recurrent neural network (RNN), a generative adversarial network (GAN), etc. By selecting an appropriate neural network structure and training the neural network structure with sample data, an aging model which can predict the battery capacity can be obtained. The regression tree fitting includes common binary trees. For example, a binary tree is used for recursively dividing a prediction space into several subsets, and the distribution of Y within these subsets is continuous and uniform. Leaf nodes in the tree correspond to different divided regions, and the division is determined by splitting rules associated with each internal node. By traversing from the root to the leaf nodes, a prediction sample is assigned with a unique leaf node, and the conditional distribution of Y at this node is also determined. Specific establishing steps of different aging models are not repeated herein.

In an implementation provided by the present disclosure, the battery state parameters include: at least two of current, voltage, temperature, state of charge, storage time, depth of discharge, and coulombic efficiency. The more input parameters there are, the more accurate the obtained battery capacity will be. In a specific scenario, those skilled in the art select, based on practical conditions and measurement conditions, at least two of the above battery state parameters for combination, to obtain a more accurate battery capacity.

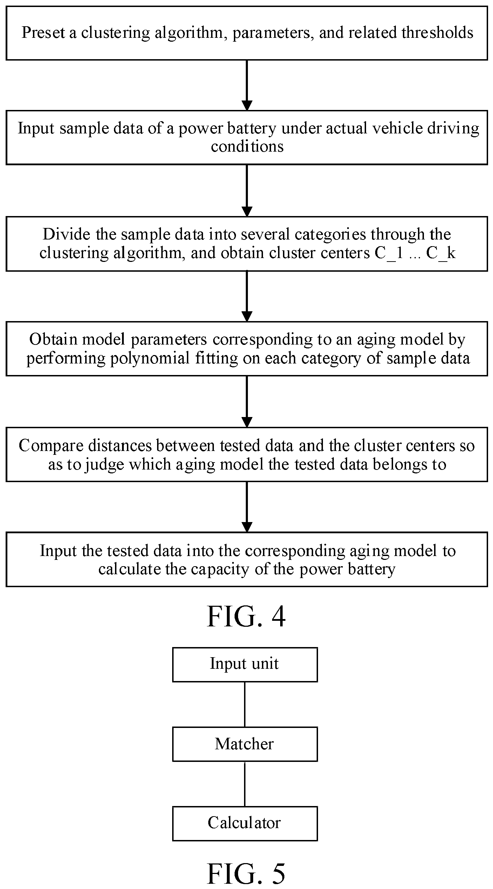

FIG. 4 is a schematic flowchart of an implementation of a method for predicting a capacity of a power battery according to the implementation of the present disclosure, as shown in FIG. 4. In this implementation, the method for predicting a capacity of a power battery includes following steps:

(1) The clustering algorithm, parameters and related thresholds are preset.
(2) The sample data of the power battery under actual vehicle driving conditions is input.
(3) The sample data is divided into several categories through the clustering algorithm, and clustering centers C 1, ... , Ck are obtained.
(4) Model parameters corresponding to an aging model are obtained by performing a statistical model such as polynomial fitting, neural network fitting, and regression tree fitting on each category of sample data.

$$Cap = f(I, V, T, SOC, t, DOD, \mu)$$

(5) Distances between to-be-tested data and the clustering centers are compared so as to judge which aging model the to-be-tested data belongs to.
(6) The to-be-tested data is input into the corresponding aging model to calculate the capacity of the power battery.

FIG. 5 is a schematic structural diagram of an apparatus for predicting a capacity of a power battery according to the implementation of the present disclosure, as shown in FIG. 5. In this implementation, the apparatus for predicting a capacity of a power battery includes: an input unit, configured to acquire battery state parameters; a matcher, configured to be matched with the battery state parameters, so as to determine an aging model adopted by the battery state parameters from multiple aging models, where the multiple aging models are in one-to-one correspondence with several categories of sample data divided by a clustering algorithm, and each of the aging models includes a mapping relationship between the battery state parameters and the battery capacity; and a calculator, configured to input the battery state parameters into the adopted aging model, to obtain the corresponding battery capacity.

The specific limitations on various modules (the input unit, the matcher, and the calculator) in the apparatus for predicting a capacity of a power battery may be referred to the limitations on a method for predicting a capacity of a power battery in the above, which are not repeated herein. The various modules in the above apparatus may be all or partly implemented by software, hardware, and a combination thereof. The above various modules may be embedded in or independent of a processor in a computer device in a hardware form, and may also be stored in a memory of the computer device in a software form, so that the processor can call and execute the corresponding operations of the various modules.

In an implementation provided by the present disclosure, a device for predicting a capacity of a power battery is further provided, and includes: at least one processor, and a memory connected with the at least one processor. The memory stores instructions executable by the at least one processor, and the at least one processor implements a foregoing method for predicting a capacity of a power battery by executing the instructions stored in the memory. The controller or processor mentioned herein has the functions of numerical computation and logical operations, and at least has a central processing unit (CPU) with the data processing capability, a random access memory (RAM), a read-only memory (ROM), multiple I/O ports, and an interrupt system, etc. The processor includes a core, and the core invokes a corresponding program unit from the memory. There may be one or more cores, and the foregoing method is implemented by adjusting core parameters. The memory may include forms such as a volatile memory, the random access memory (RAM), and/or a non-volatile memory, such as the read-only memory (ROM) or a flash memory (flash RAM) in a computer-readable medium.

In an implementation provided by the present disclosure, a computer-readable storage medium stores a computer program. The computer program, when executed by a processor, implements a foregoing method for predicting a capacity of a power battery.

Those skilled in the art should understand that the embodiments of the present disclosure may be provided as a method, a system, or a computer program product. Therefore, the present disclosure may use a form of hardware-only embodiments, software-only embodiments, or embodiments combining software and hardware. In addition, the present disclosure may use a form of a computer program product implemented on one or more computer-usable storage media (including but not limited to a disk memory, a CD-ROM, an optical memory, and the like) containing computer-usable program code.

The present disclosure is described with reference to flowcharts and/or block diagrams of the method, the device (system), and the computer program product in the embodiments of the present disclosure. It is be understood that computer program instructions can implement each procedure and/or block in the flowcharts and/or block diagrams, and a combination of procedures and/or blocks in the flowcharts and/or block diagrams. These computer program instructions may be provided to a general-purpose computer, a special-purpose computer, an embedded processor, or a processor of another programmable data processing device to generate a machine, so that an apparatus configured to implement functions specified in one or more procedures in the flowcharts and/or one or more blocks in the block diagrams is generated by using instructions executed by the computer or the processor of the another programmable data processing device.

These computer program instructions may alternatively be stored in a computer-readable memory that can instruct the computer or the another programmable data processing device to work in a specific manner, so that the instructions stored in the computer-readable memory generate an artifact that includes an instruction apparatus. The instruction apparatus implements functions specified in one or more procedures in the flowcharts and/or in one or more blocks in the block diagrams.

These computer program instructions may further be loaded onto the computer or the another programmable data processing device, so that a series of operations and steps are performed on the computer or the another programmable device, thereby generating computer-implemented processing. Therefore, the instructions executed on the computer or the another programmable device provide steps for implementing functions specified in one or more procedures in the flowcharts and/or in one or more blocks in the block diagrams.

In a typical configuration, the computer device includes one or more central processing units (CPUs), an input/output interface, a network interface, and an internal memory.

The memory may include forms such as the volatile memory, the random access memory (RAM), and/or the non-volatile memory, such as the read-only memory (ROM) or the flash memory (flash RAM) in the computer-readable medium. The memory is an example of the computer-readable medium.

The computer-readable medium includes a non-volatile medium and a volatile medium, a removable medium and a non-removable medium, which may implement storage of information by using any method or technology. The information may be a computer-readable instruction, a data structure, a program module, or other data. Examples of the storage medium of the computer include but not limited to a phase-change memory (PRAM), a static random access memory (SRAM), a dynamic random access memory (DRAM), or other types of random access memory (RAM), the read-only memory (ROM), an erasable programmable read-only memory (EEPROM), a flash memory or another storage technology, a compact disc read-only memory (CD-ROM), a digital versatile disc (DVD) or another optical storage, a cartridge tape, a magnetic tape, a magnetic disk storage or another magnetic storage device, or any other non-transmission medium, which may be configured to store information accessible by the computing device. According to limitations of this specification, the computer-readable medium does not include transitory computer-readable media, such as a modulated data signal and a modulated carrier.

It is to be further noted that, the term "include," "comprise," or their any other variants are intended to cover a non-exclusive inclusion, so that a process, a method, a product, or a device that includes a series of elements not only includes such elements, but also includes other elements not expressly listed, or further includes elements inherent to such a process, method, product, or device. Unless otherwise specified, an element limited by "include a/an..." does not exclude other same elements existing in the process, the method, the product, or the device that includes the element.

The foregoing descriptions are merely the embodiments of the present disclosure, but are not intended to limit the present disclosure. For those skilled in the art, various modifications and variations can be made to the present disclosure. Any modification, equivalent replacement, improvement, etc. made within the spirit and principle of the present disclosure shall fall within the scope of the protection of the present disclosure.

**Claims**

1.  A method for predicting a capacity of a power battery, comprising:

    acquiring sample data of the power battery;
    dividing the sample data into several categories by using a clustering algorithm, each category having a corresponding aging model and a feature identifier, and the aging model being obtained by the following steps: determining a fitting relationship in the aging model, and determining parameters in the fitting relationship according to sample data of the corresponding type of the aging model, the feature identifier being used for identifying features of the sample data of the corresponding category;

acquiring battery state parameters of a to-be-tested power battery;

determining an aging model adopted by the battery state parameters from a plurality of aging models; and

inputting the battery state parameters into the adopted aging model to obtain a corresponding battery capacity.

2. The method according to claim 1, wherein the sample data of the power battery comprises: a plurality of sets of historical data for a same model of power battery under actual vehicle driving conditions.

3. The method according to claim 1 or 2, wherein the dividing the sample data into several categories by using a clustering algorithm comprises:

presetting the clustering algorithm, and determining clustering parameters in the clustering algorithm;

dividing the sample data into a core point or a boundary point according to the clustering parameters; and

constructing categories according to the core point, and dividing the sample data into the several categories.

4. The method according to claim 3, wherein the clustering algorithm is a DBSCAN algorithm; and
the clustering parameters comprise a radius of neighborhood and a neighborhood count threshold.

5. The method according to any one of claims 1 to 4, wherein the feature identifier is a clustering center; and
the determining an aging model adopted by the battery state parameters from a plurality of aging models comprises:

calculating a distance between the battery state parameters and a clustering center corresponding to each category; and

selecting a nearest aging model as the aging model adopted by the battery state parameters.

6. The method according to any one of claims 1 to 5, wherein the fitting relationship comprises polynomial fitting, neural network fitting, or regression tree fitting.

7. The method according to any one of claims 1 to 6, wherein the battery state parameters comprise: at least two of current, voltage, temperature, state of charge, storage time, depth of discharge, and coulombic efficiency.

8. An apparatus for predicting a capacity of a power battery, comprising:

an input unit, configured to acquire battery state parameters;

a matcher, configured to be matched with the battery state parameters, so as to determine an aging model adopted by the battery state parameters from a plurality of aging models, the plurality of aging models being in one-to-one correspondence with several categories of sample data divided by a clustering algorithm, and each of the aging models comprising a mapping relationship between the battery state parameters and a battery capacity; and

a calculator, configured to input the battery state parameters into the adopted aging model, to obtain the corresponding battery capacity.

9. A device for predicting a capacity of a power battery, comprising:

at least one processor; and a memory connected with the at least one processor, wherein the memory stores instructions executable by the at least one processor, and the at least one processor implements a method for predicting a capacity of a power battery according to any one of claims 1 to 7 by executing the instructions stored in the memory.

10. A computer-readable storage medium, storing a computer program, wherein the program, when executed by a processor, implements a method for predicting a capacity of a power battery according to any one of claims 1 to 7.

| | |
|---|---|
| Acquire sample data of a power battery | S01 |

↓

| | |
|---|---|
| Divide the sample data into several categories by using a clustering algorithm, each category having a corresponding aging model and a feature identifier | S02 |

↓

| | |
|---|---|
| Acquire battery state parameters of a to-be-tested power battery | S03 |

↓

| | |
|---|---|
| Determine an aging model adopted by the battery state parameters from multiple aging models | S04 |

↓

| | |
|---|---|
| Input the battery state parameters into the adopted aging model to obtain a corresponding battery capacity | S05 |

FIG. 1

FIG. 2

FIG. 3

Preset a clustering algorithm, parameters, and related thresholds

Input sample data of a power battery under actual vehicle driving conditions

Divide the sample data into several categories through the clustering algorithm, and obtain cluster centers C_1 ... C_k

Obtain model parameters corresponding to an aging model by performing polynomial fitting on each category of sample data

Compare distances between tested data and the cluster centers so as to judge which aging model the tested data belongs to

Input the tested data into the corresponding aging model to calculate the capacity of the power battery

FIG. 4

Input unit

Matcher

Calculator

FIG. 5

## INTERNATIONAL SEARCH REPORT

| | International application No. |
|---|---|
| | **PCT/CN2022/099307** |

**A. CLASSIFICATION OF SUBJECT MATTER**

G06Q 10/04(2012.01)i

According to International Patent Classification (IPC) or to both national classification and IPC

**B. FIELDS SEARCHED**

Minimum documentation searched (classification system followed by classification symbols)

G06Q10/-; G06K9/-; G06N3/-

Documentation searched other than minimum documentation to the extent that such documents are included in the fields searched

Electronic data base consulted during the international search (name of data base and, where practicable, search terms used)

CNABS; CNTXT; VEN; USTXT; WOTXT; EPTXT; CNKI; IEEE: 电池, 容量, 寿命, 预测, 预估, 聚类, 老化, 退化, 衰减, 模型, 建模, 参数, 电压, 温度, 荷电状态, 放电深度, 库里效率, battery, cell, capacity, life, predict, forecast, estimate, cluster, DBSCAN, K-Means, age, retrogradation, degradation, attenuation, model, parameter, voltage, temperature, state of charge, SOC, depth of discharge, DOD, garage efficiency

**C. DOCUMENTS CONSIDERED TO BE RELEVANT**

| Category* | Citation of document, with indication, where appropriate, of the relevant passages | Relevant to claim No. |
|---|---|---|
| X | US 2020284846 A1 (MITSUBISHI ELECTRIC RESEARCH LABORATORIES, INC.) 10 September 2020 (2020-09-10) description, paragraphs 0038-0096 | 1-10 |
| Y | CN 112505569 A (ZHUHAI ZHONGLI NEW ENERGY TECHNOLOGY CO., LTD.) 16 March 2021 (2021-03-16) description, paragraphs 0039-0127 | 1-10 |
| Y | US 2016239592 A1 (NEC LABORATORIES AMERICA, INC.) 18 August 2016 (2016-08-18) description, paragraphs 0028-0118 | 1-10 |
| Y | CN 103954913 A (HARBIN INSTITUTE OF TECHNOLOGY SHENZHEN GRADUATE SCHOOL) 30 July 2014 (2014-07-30) description, paragraphs 0076-0182 | 1-10 |
| A | US 2013090900 A1 (BATTELLE ENERGY ALLIANCE LLC.) 11 April 2013 (2013-04-11) entire document | 1-10 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 August 2022** | **26 August 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2022/099307** |

**C.      DOCUMENTS CONSIDERED TO BE RELEVANT**

| Category* | Citation of document, with indication, where appropriate, of the relevant passages | Relevant to claim No. |
|---|---|---|
| A | CN 111537884 A (SHENZHEN INSTITUTES OF ADVANCED TECHNOLOGY, CHINESE ACADEMY OF SCIENCES) 14 August 2020 (2020-08-14)<br>entire document | 1-10 |

Form PCT/ISA/210 (second sheet) (January 2015)

**INTERNATIONAL SEARCH REPORT**
Information on patent family members

International application No.

**PCT/CN2022/099307**

| Patent document cited in search report | | | Publication date (day/month/year) | Patent family member(s) | | | Publication date (day/month/year) |
|---|---|---|---|---|---|---|---|
| US | 2020284846 | A1 | 10 September 2020 | WO | 2020179120 | A1 | 10 September 2020 |
| | | | | JP | 2022514992 | A | 16 February 2022 |
| | | | | US | 10921383 | B2 | 16 February 2021 |
| CN | 112505569 | A | 16 March 2021 | | None | | |
| US | 2016239592 | A1 | 18 August 2016 | | None | | |
| CN | 103954913 | A | 30 July 2014 | CN | 103954913 | B | 30 June 2017 |
| US | 2013090900 | A1 | 11 April 2013 | WO | 2013103414 | A2 | 11 July 2013 |
| | | | | US | 9625532 | B2 | 18 April 2017 |
| CN | 111537884 | A | 14 August 2020 | CN | 111537884 | B | 29 April 2022 |
| | | | | WO | 2021208079 | A1 | 21 October 2021 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110711103